# EUROPEAN PATENT SPECIFICATION

(11) **EP 4 633 323 B1**
(45) Date of publication and mention of the grant of the patent: **11.11.2026**
(21) Application number: 25167714.2
(22) Date of filing: 01.04.2025
(51) Int. Cl.: H10D 30/67, H10D 30/00, H10D 84/01, H10W 20/41, H10W 20/40, H10D 30/01, H10D 64/01, H10W 20/00, H10D 64/23, H10D 62/10, B82Y 10/00, H10D 84/83, H10P 14/40

(54) **METHOD OF FORMING BACKSIDE CONTACT OF SEMICONDUCTOR DEVICE**
VERFAHREN ZUR HERSTELLUNG EINES RÜCKSEITENKONTAKTS EINES HALBLEITERBAUELEMENTS
PROCÉDÉ DE FORMATION D'UN CONTACT ARRIÈRE DE DISPOSITIF À SEMI-CONDUCTEUR

(30) Priority: 10.04.2024 US 202463632046 P; 23.09.2024 US 202418893213
(43) Date of publication of application: 15.10.2025
(73) Proprietor: SAMSUNG ELECTRONICS CO., LTD., Yeongtong-gu Suwon-si, Gyeonggi-do 16677 (KR)
(72) Inventor: KIM, Byounghoon, 16677 Suwon-si, Gyeonggi-do (KR); LEE, Jongjin, 16677 Suwon-si, Gyeonggi-do (KR); CHUNG, Wonkeun, 16677 Suwon-si, Gyeonggi-do (KR); JUNG, Kang-Min, 16677 Suwon-si, Gyeonggi-do (KR); SEO, Kang-Ill, 16677 Suwon-si, Gyeonggi-do (KR)
(74) Representative: Kuhnen & Wacker Patent- und Rechtsanwaltsbüro PartG mbB

(56) References cited:
- EP-A1- 4 345 905
- US-A1- 2021 351 303
- US-A1- 2022 139 911
- US-A1- 20240 088 233
- US-A1- 20240 105 799

## Description

### TECHNICAL FIELD

The present disclosure generally relates to the field of semiconductor devices and, more particularly, to semiconductor devices having backside (BS) contacts.

### BACKGROUND OF THE INVENTION

Integrated circuit (IC) devices, chips, and/or blocks may receive power and data signals from one or more external sources (e.g., a power source and a data source) as part of an operation. Some IC devices may receive power and data signals via front-side (FS) conductive structures. For example, an IC device may include an FS power distribution network (FSPDN) having one or more components that are formed during back-end-of-line (BEOL) processes, and conductive structures for data signals may be on the same side of an IC device as the FSPDN. IC devices may include various transistor structures, including, for example, two-dimensional (2D) planar structures, fin field-effect transistors (FinFETs), gate-all-around transistors, multi-bridge channel FETs (NMCFETsTM), and stacked transistors (e.g., three-dimensional (3D) stacked transistors).

More recently, backside PDNs (BSPDNs), in which a BS of an IC device is used as a PDN, have also been developed. For example, a power rail may be used in a BSPDN of an IC device, and may be on a side of the IC device (e.g., a side of a substrate of the IC device) opposite from active components (e.g., transistors) of the IC device. Moreover, conductive structures for data signals may be on an FS of the IC device, and thus the BSPDN and the conductive structures for the data signals may be on opposite sides of the IC device.

US 2024/088233 A1 discloses a semiconductor device including a source/drain having a height, a length, and a width. A full wrap-around contact surrounds a partial length of the source/drain, wherein the full wrap-around contact includes a partial front-side wrap-around contact from a front side of a substrate and a partial back-side wrap-around contact from a back side of the substrate.

EP 4 345 905 A1 discloses a field-effect transistor structure comprising: a channel structure; a 1st source/drain region and a 2nd source/drain region connected to each other through the channel structure; a 1st contact plug, on a top surface of the 1st source/drain region, connected to a 1st voltage source or a circuit element through a back-end-of-line, BEOL, structure; and a 2nd contact plug, on a bottom surface of the 2nd source/drain region, connected to the 1st voltage source, through a backside power rail, or another circuit element, wherein the 1st source/drain region and the 2nd source/drain region have a substantially same height.

US 2024/105799 A1 discloses a semiconductor device, comprising: at least one field-effect transistor on a backside interlayer dielectric; an epitaxial contact placeholder embedded in, and surrounded by, the backside interlayer dielectric, wherein the epitaxial contact placeholder directly contacts a first source/drain region of the at least one field-effect transistor; and a self-aligned direct backside contact embedded in, and surrounded by, the backside interlayer dielectric, wherein the self-aligned direct backside contact directly contacts a second source/drain region of the at least one field-effect transistor, wherein the epitaxial contact placeholder extends a distance d1 into the backside interlayer dielectric from the first source/drain region, wherein the self-aligned direct backside contact extends a distance d2 into the backside interlayer dielectric from the second source/drain region, and wherein d2>d1.

US 2022/139911 A1 discloses A transistor arrangement, comprising: a backside layer of a first dielectric material; an electrically conductive line over the backside layer; a nanoribbon of a channel material over the electrically conductive line, the nanoribbon having a long axis that is substantially parallel to the backside layer; a transistor that includes: a channel portion that includes a portion of the channel material of the nanoribbon, a gate stack, at least partially wrapping around the channel portion, and a first source or drain (S/D) region and a second S/D region in the nanoribbon, on either side of the channel portion; and a backside S/D contact that includes a via that extends through the backside layer, the via having a first portion that has a first end in contact with the electrically conductive line, and further having a second portion that has a second end in contact with the first S/D region, where a dimension of the first S/D region in a direction of the long axis of the nanoribbon is smaller than a dimension of the first portion of the via in the direction of the long axis of the nanoribbon.

### SUMMARY OF THE INVENTION

A method of forming a semiconductor device, according to the appended set of claims.

### BRIEF DESCRIPTION OF THE DRAWINGS

FIG. 1A is a schematic block diagram of a device according to some embodiments herein.
FIG. 1B is a schematic block diagram of the IC of FIG. 1A.
FIG. 1C is an example cross-sectional view of the IC of FIG. 1B along a first direction.
FIG. 1D is an enlarged view of a portion of FIG. 1C.
FIG. 1E is an example cross-sectional view of the IC of FIG. 1B along a second direction.
FIGs. 2A, 2B, 2C, 2D, 2E, and 2F are cross-sectional views illustrating operations of forming the structure shown in FIGs. 1C and 1E.
FIG. 3 is a flowchart corresponding to the operations shown in FIGs. 2A, 2B, 2C, 2D, 2E, and 2F.

### DETAILED DESCRIPTION

To improve power rail effectiveness and voltage drop (i.e., IR drop), BSPDN structures have been developed. BSPDN structures may be formed on the BS of a semiconductor chip (or IC device) rather than on the FS. The BSPDN structure may include a power delivery network that includes one or more power rails. An example of improved power rail effectiveness is high power delivery performance. Different ways to connect from the FS to the BS include, for example, a front via BS power rail (FV-BPR) and a direct BS contact (DBC). The DBC may be more effective in terms of process capability and dimension limitations than other ways of connecting the FS to the BS. As contacted poly pitch (CPP) is becoming smaller, however, DBCs are becoming more difficult to form due to patterning issues such as photo overlay and high aspect ratio etch process (which may result in voids in the DBCs).

One approach to forming a BS contact, such as a DBC, is to use a saturable absorption silicon (SASI) scheme under a nanosheet stack to protect a sub-stack region and increase the process margin. SASI height can be important because a process variation with respect to a placeholder (e.g., a placeholder BS contact) height may need to be finely controlled. Various process variations may exist due to, for example, a canyon space etch, depth reactive-ion etching (RIE), epitaxial growth, and so forth. It may be difficult to maintain a SASI layer for a narrowed-pitch process, such as a pitch that is smaller than 48 nanometers (nm) due to narrow canyon space, and to maintain a hardmask thickness. Accordingly, a non-SASI scheme may be used to reduce these kinds of variations.

The height of the placeholder is typically controlled by etching and silicon germanium/silicon growth variation. This height can vary too much, however, using such a technique. For example, if the placeholder has too high of a margin (e.g., too high of a height), then it can block one or more of the nanosheets from contacting an adjacent epitaxial S/D region. If, on the other hand, the placeholder has too low of a height, then damage may occur to the S/D region, and/or to a silicon layer that is between the placeholder and the S/D region, when a backside process (e.g., a silicon-removal process) is performed to remove the placeholder.

Pursuant to embodiments herein, methods of forming semiconductor (e.g., semiconductor IC) devices are provided that include controlling the height of a placeholder by forming a conductive spacer comprising a barrier metal. As an example, the height of the spacer can be controlled by performing a chamfering method in a non-SASI scheme. With the chamfering method, a placeholder height target can be lower than a typical height, thereby allowing the process to have a wider margin than a typical method. Moreover, the barrier metal is used instead of an insulating nitride-based film, and can thus help to reduce contact resistance at the BS.

Some examples of embodiments of the present disclosure will be described in greater detail with reference to the attached figures. The term disclosure is to be understood literally. Hence, while some features may be disclosed as optional with reference to the figures the invention including its essential features is solely defined by the appended set of claims.

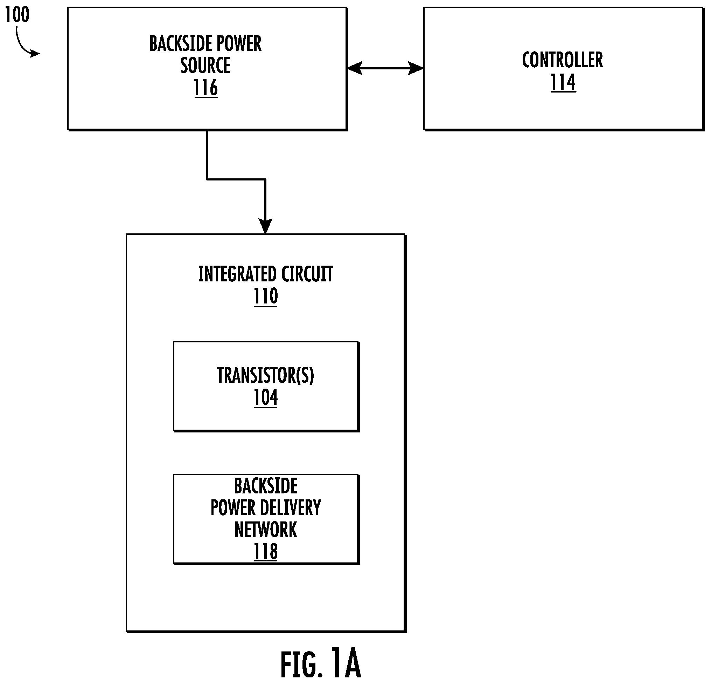

FIG. 1A is a schematic block diagram of a semiconductor device 100 according to some embodiments herein. The device 100 includes an IC 110, which has one or more transistors 104, and a BSPDN 118. For example, a transistor 104 may be a nanosheet transistor that includes a stack of nanosheet layers.

The device 100 also may include a BS power source 116 that is coupled to the IC 110. The BS power source 116 may provide power signals to the IC 110 at one or more voltage levels. As an example, the BS power source 116 may be configured to provide one or more voltages between 0.4-1.1 volts to the BSPDN 118.

The device 100 further may include a controller 114 that is coupled to the BS power source 116. The controller 114 may include one or more microprocessors that are configured to control operations of the BS power source 116. For example, the controller 114 may include a microprocessor that is configured to turn the BS power source 116 on or off. The controller 114 and the BS power source 116 may be used to perform chip-level power gating (e.g., turning on or off the entire IC 110) and/or block-level power gating (e.g., turning on or off individual portions of the IC 110, such as the transistor(s) 104). As shown in FIG. 1A, the controller 114 may be external to (i.e., outside of) the IC 110 that includes the transistor(s) 104.

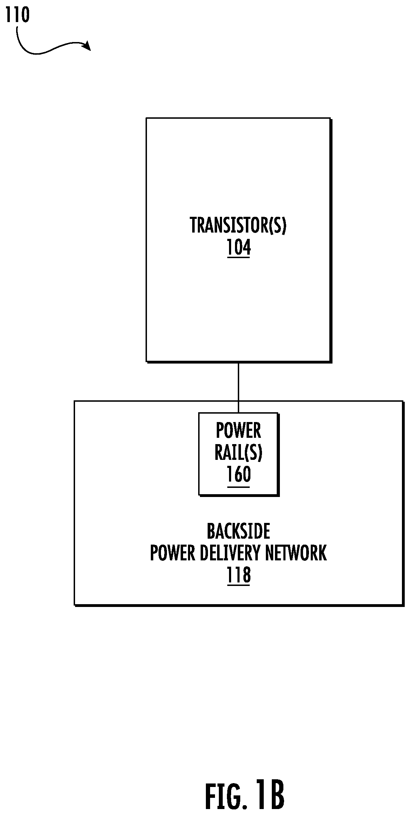

FIG. 1B is a schematic block diagram of the IC 110. As shown in FIG. 1B, the IC 110 may include the BSPDN 118 and one or more transistors 104 that are electrically connected to the BSPDN 118. For example, the BSPDN 118 may include one or more power rails 160 (e.g., power lines) that are coupled to the transistor(s) 104. Because they are part of the BSPDN 118, the power rails 160 may also be referred to herein as "backside" (i.e., BS) power rails, each of which may be provided by a respective conductive (e.g., metal) line on the BS of the IC 110.

A transistor 104 may overlap a BS power rail 160 in a vertical direction Z. The BS power rail 160 may extend longitudinally (i.e., longest) in a horizontal direction Y (and/or in another horizontal direction X), and may be electrically connected to the transistor 104. In some embodiments, the horizontal direction Y may be perpendicular to the vertical direction Z and perpendicular to the horizontal direction X. The BS power rail 160 is an example of a BS interconnect, such as a BS conductive line/wire. The element 160 may thus also be referred to herein as a "BS interconnect," a "BS conductive line," or a "BS conductive wire."

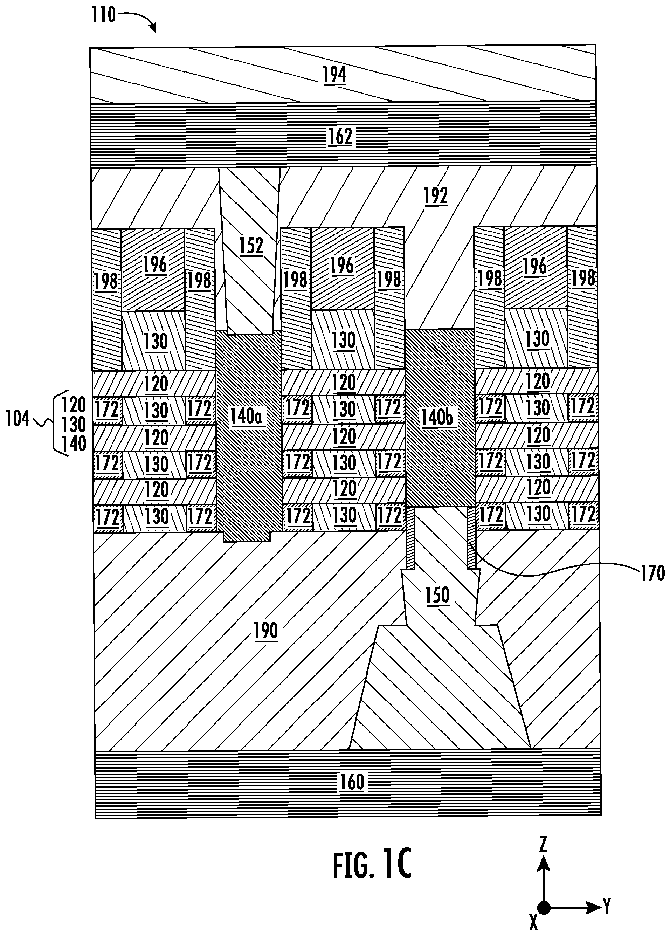

FIG. 1C is an example cross-sectional view of the IC 110 along the horizontal direction Y. As shown in FIG. 1C, one or more BS contacts 150 may couple a BS power rail 160 of the BSPDN 118 (FIG. 1B) to a transistor 104. For example, the IC 110 may include one BS contact 150 that couples the BS power rail 160 to an overlying S/D region 140b of the transistor 104. The BS contact 150 may be a conductive (e.g., metal) contact that has a lower surface that is on (e.g., that contacts) an upper surface of the BS power rail 160. As an example, the BS contact 150 may comprise cobalt (Co), ruthenium (Ru), molybdenum (Mo), tungsten (W), or another metal. According to some embodiments, the BS contact 150 may be a DBC that is part of the BSPDN 118.

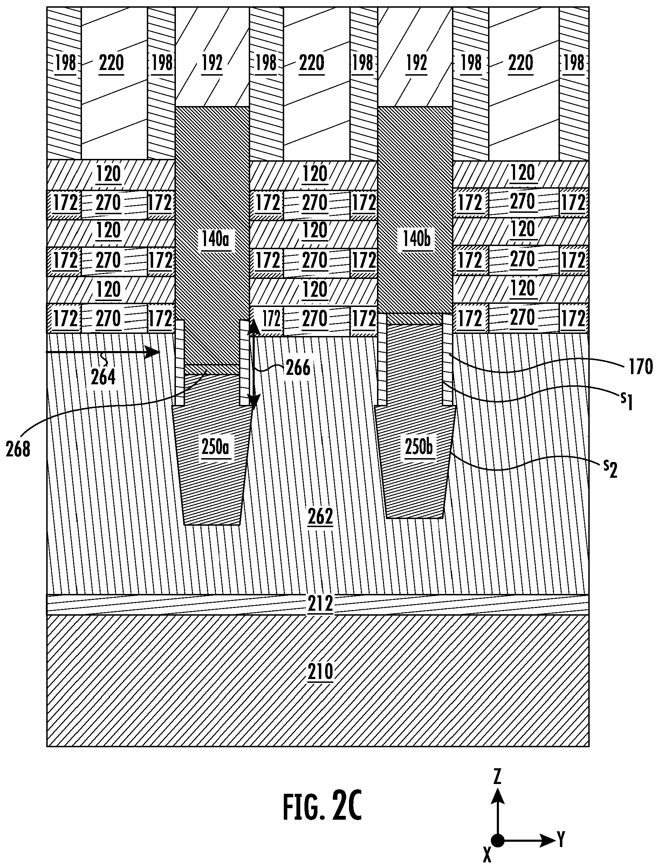

The BS contact 150 may be coupled between the S/D region 140b and the BS power rail 160. The BS contact 150 may thus also be referred to herein as a "BS S/D contact." In some embodiments, an upper surface of the BS contact 150 may be in contact with a lower surface of the S/D region 140b. In other embodiments, a semiconductor (e.g., silicon) buffer layer may be between the BS contact 150 and the S/D region 140b. For example, a semiconductor layer 268 that can be a semiconductor buffer layer is described herein in further detail with respect to FIG. 2C.

A conductive spacer 170 may be on an upper portion of the BS contact 150. The conductive spacer 170 may comprise a relatively thin layer that reduces contact resistance between the BS contact 150 and the S/D region 140b. Moreover, the conductive spacer 170 may protrude upward in the vertical direction Z beyond an upper surface of a BS isolation region 190, and thus may overlap a gate 130 in the horizontal direction Y.

In some embodiments, the conductive spacer 170 may be a metal spacer. For example, the conductive spacer 170 may comprise a barrier metal. According to some embodiments, the barrier metal may comprise titanium nitride and may be free of (i.e., may not include) silicon. The conductive spacer 170 may thus comprise a different material from that of a conventional insulating spacer, such as a silicon nitride spacer, that may typically be on an upper portion of a BS contact 150.

The gate 130 may be on a stack of channel layers 120 of the transistor 104. The channel layers 120, the gate 130, and a pair of S/D regions 140a, 140b (collectively, 140) are each part of the transistor 104. Sidewalls of the channel layers 120 may contact, and be electrically connected to, the S/D regions 140. The gate 130 is a conductive gate that may be between (in the vertical direction Z) the channel layers 120, and may be spaced apart from the S/D regions 140 (and from the conductive spacer 170) in the horizontal direction Y by insulating spacers 172. The gate 130 may include a metal or a semiconductor material. As an example, the gate 130 may include aluminum (Al), tungsten (W), or another metal.

The spacers 172 may be on sidewalls of the gate 130 and between, in the vertical direction Z, the channel layers 120. In some embodiments, upper ones of the spacers 172 may contact the S/D regions 140 and sidewalls of the gate 130, and lower (e.g., lowest) ones of the spacers 172 may contact sidewalls of the conductive spacer 170 and sidewalls of the gate 130. According to some embodiments, the spacers 172 may comprise, for example, nitrogen (e.g., silicon nitride). The spacers 172 may also be referred to herein as "inner spacers," as they may be situated between nanosheet/nanowire channels within a transistor.

An FS contact 152 may be on (e.g., in contact with) an upper surface of a first S/D region 140a that overlies the BS isolation region 190 and does not overlie the BS contact 150. The FS contact 152 may therefore overlap the BS isolation region 190 in the vertical direction Z. The FS contact 152 may be a conductive (e.g., metal) contact that may be electrically isolated from the gate 130 by an isolation region 198 (e.g., a sidewall spacer). According to some embodiments, another isolation region 196 (e.g., a capping layer) may be on an upper surface of the gate 130. The isolation region 196 may comprise, for example, an oxide. In some embodiments, an insulating material of the isolation region 196 may be different from that of the isolation region 198.

An FS isolation region 192 may be on an upper surface of a second S/D region 140b, an upper surface of the isolation region 196, and an upper surface of the isolation region 198. According to some embodiments, the FS isolation region 192 may comprise a different insulating material from that of the isolation region 196 and/or the isolation region 198. Moreover, the FS isolation region 192 may comprise the same insulating material as that of the BS isolation region 190. As an example, the BS isolation region 190 and the FS isolation region 192 may each comprise an oxide.

An upper portion of the FS contact 152 may be in the FS isolation region 192 and may be electrically connected to (e.g., in contact with a lower surface of) an overlying FS conductive layer 162. In some embodiments, the FS conductive layer 162 may comprise the same conductive material (e.g., the same metal) as that of the BS power rail 160. Moreover, the FS conductive layer 162 may be formed by a BEOL operation/process, which may provide multilayered interconnections, such as wirings and vias.

A wafer 194 may be on an upper surface of the FS conductive layer 162. The FS conductive layer 162 may thus be between, in the vertical direction Z, the wafer 194 and the FS contact 152. The wafer 194 may comprise, for example, a carrier wafer/substrate.

For simplicity of illustration, a gate insulation layer is omitted from view in FIG. 1C. It will be understood, however, that a gate insulation layer may extend between each channel layer 120 and the gate 130. The gate insulation layers may wrap around the channel layers 120 (e.g., in a cross-section along the horizontal direction X) and may be thinner than the spacers 172. Moreover, according to some embodiments, the structure in FIG. 1C does not include a bottom dielectric isolation (BDI) layer under the channel layers 120.

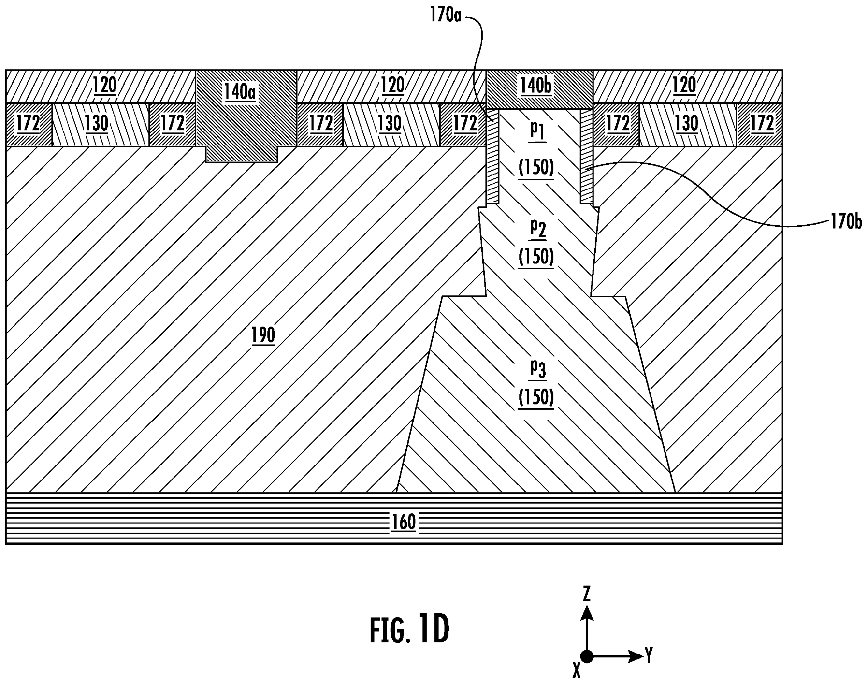

FIG. 1D is an enlarged view of a portion of FIG. 1C that includes the BS contact 150. As shown in FIG. 1D, the BS contact 150 includes an upper portion p₁ having sidewalls that are adjacent to conductive spacers 170.

An upper surface of the upper portion p₁ may be adjacent (e.g., in contact with) a lower surface of the overlying S/D region 140b, which may also be referred to herein as the "second" S/D region. Upper surfaces of the conductive spacers 170a, 170b may also be adjacent (e.g., in contact with) the second S/D region 140b. In some embodiments, the upper surfaces of the conductive spacers 170a, 170b may be coplanar with the upper surface of the upper portion p₁.

According to some embodiments, the conductive spacers 170a, 170b and the upper portion p₁ of the BS contact 150 may protrude upward in the vertical direction Z beyond a level of an upper surface of the BS isolation region 190. For example, lower portions of the conductive spacers 170a, 170b may be in the BS isolation region 190, and upper portions of the conductive spacers 170a, 170b may overlap a lower (e.g., a lowermost) layer of the insulating spacers 172 and the gate 130 in the horizontal direction Y. Likewise, a lower region of the upper portion p₁ may be in the BS isolation region 190, and an upper region of the upper portion p₁ may overlap the lower (e.g., the lowermost) layer of the insulating spacers 172 and the gate 130 in the horizontal direction Y. Moreover, each of the conductive spacers 170a, 170b may, in some embodiments, be narrower than each of the insulating spacers 172 in the horizontal direction Y.

The BS contact 150 may also include a middle portion p₂ and a lower portion p₃ that are in the BS isolation region 190. The middle portion p₂ is between the upper portion p₁ and the lower portion p₃ in the vertical direction Z. In some embodiments, the middle portion p₂ is wider, in the horizontal direction Y, than the upper portion p₁. Similarly, the lower portion p₃ may be wider, in the horizontal direction Y, than the middle portion p₂. A lower surface of the lower portion p₃ may be adjacent (e.g., in contact with) an upper surface of the BS power rail 160. The conductive spacers 170a, 170b may be on an upper surface of the middle portion p₂. According to some embodiments, the conductive spacers 170a, 170b may be not on side surfaces of the middle portion p₂ and the lower portion p₃. Instead, the side surfaces of the middle portion p₂ and the lower portion p₃ may be in contact with the BS isolation region 190. In some embodiments, the BS contact 150 may further include a barrier layer between the middle portion p₂ and the BS isolation region 190 and/or between the lower portion p₃ and the BS isolation region 190. The barrier layer may be connected/contiguous to the conductive spacers 170a, 170b to form a unitarily integrated structure. For example, the barrier layer may include the same material as the conductive spacers 170a, 170b.

In some embodiments, the upper portion p₁ may have a constant (i.e., uniform) width in the horizontal direction Y. The sidewalls of the upper portion p₁ may thus be vertical sidewalls, which may be parallel to the vertical direction Z and may be overlapped by the second S/D region 140b in the vertical direction Z. The middle portion p₂ and the lower portion p₃, however, may each have a variable width in the horizontal direction Y. For example, the width of the middle portion p₂ may narrow as the middle portion p₂ approaches (i.e., is closer to) the lower portion p₃. The width of the lower portion p₃, on the other hand, may widen as the lower portion p₃ approaches (i.e., is closer to) the BS power rail 160. Accordingly, the middle portion p₂ and the lower portion p₃ may have sloped/angled side surfaces. Alternatively, the middle portion p₂ and the lower portion p₃ may have straight vertical sidewalls and/or may have narrower widths than those shown in FIG. 1D. As an example, the middle portion p₂ and the lower portion p₃ may have the same width as each other in the horizontal direction Y.

Some of the channel layers 120 may overlap the middle portion p₂ and the lower portion p₃ in the vertical direction Z. In contrast, FIG. 1D shows that the none of channel layers 120 may overlap the upper portion p₁ in the vertical direction Z, as the upper portion p₁ is narrower than the overlying second S/D region 140b that is horizontally adjacent (and electrically connected to) ones of the channel layers 120 that overlap the middle portion p₂ and the lower portion p₃.

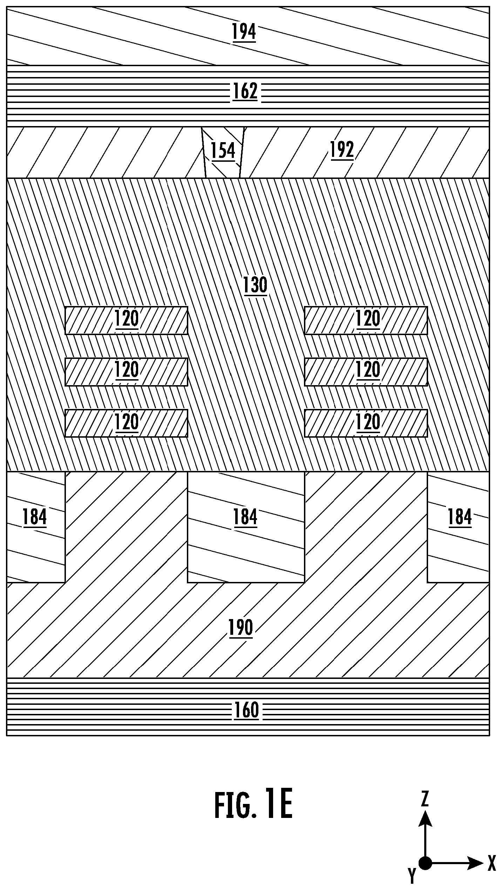

FIG. 1E is an example cross-sectional view of the IC 110 of FIG. 1B along the horizontal direction X. As shown in FIG. 1E, the gate 130 may surround the channel layers 120. For simplicity of illustration, a gate insulation layer is omitted from view in FIG. 1E. It will be understood, however, that a gate insulation layer may extend between each channel layer 120 and the gate 130. The gate insulation layers may wrap around the channel layers 120.

A shallow trench isolation (STI) region 184 may be in the BS isolation region 190. In some embodiments, the STI region 184 may include a different insulating material (e.g., a different oxide) from that of the BS isolation region 190. According to some embodiments, the STI region 184 may be overlapped by the gate 130, but not necessarily by the channel layers 120, in the vertical direction Z. Moreover, a gate contact 154 may be on the gate 130 and in the FS isolation region 192. For example, the gate contact 154 may be coupled between the gate 130 and the FS conductive layer 162. The gate contact 154 may, in some embodiments, include the same conductive material (e.g., the same metal) as the BS contact 150 (FIG. 1D) and/or the FS contact 152 (FIG. 1C).

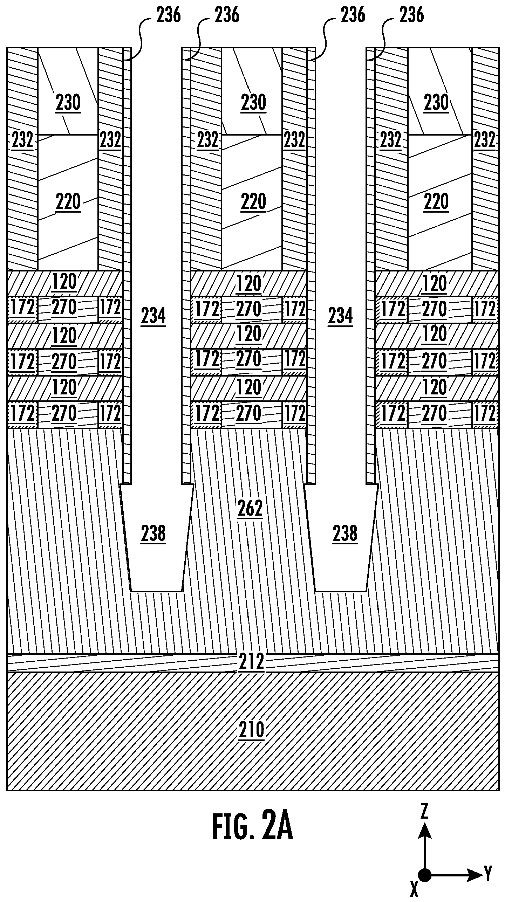

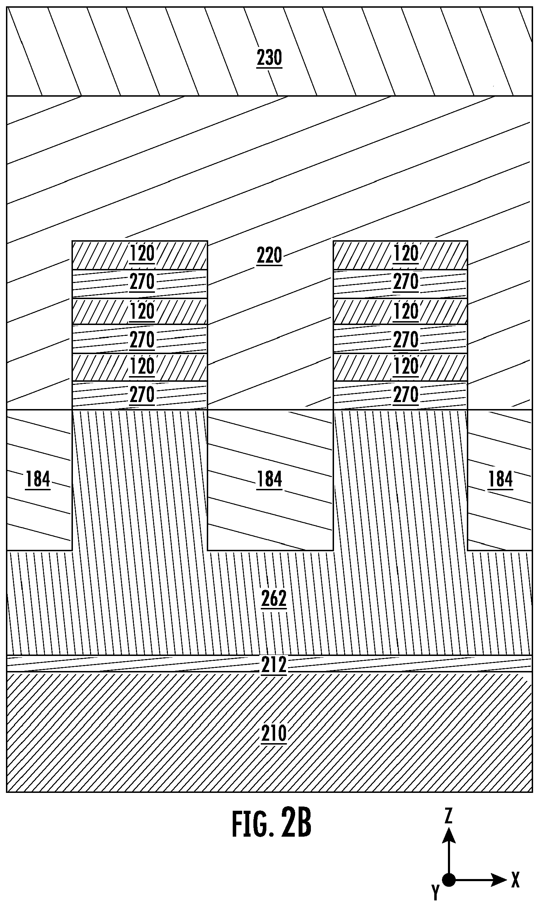

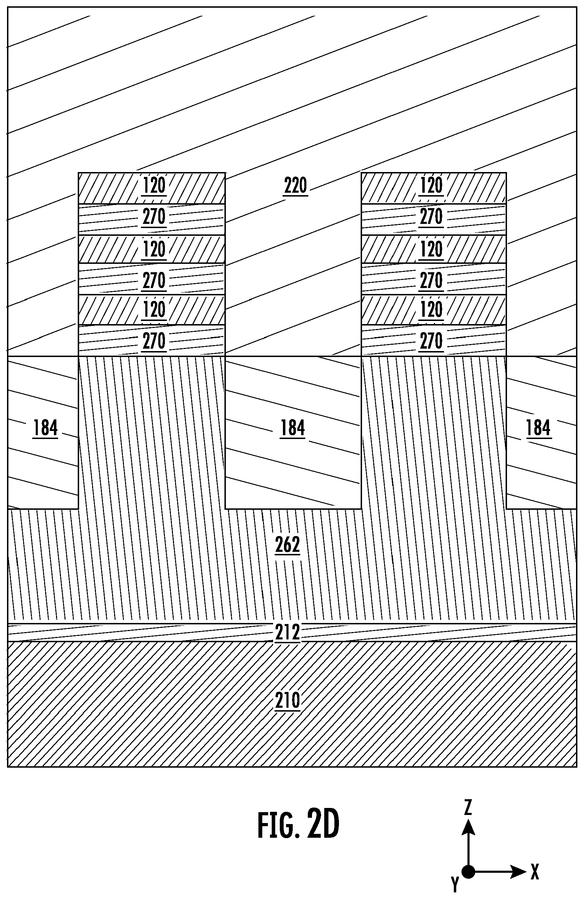

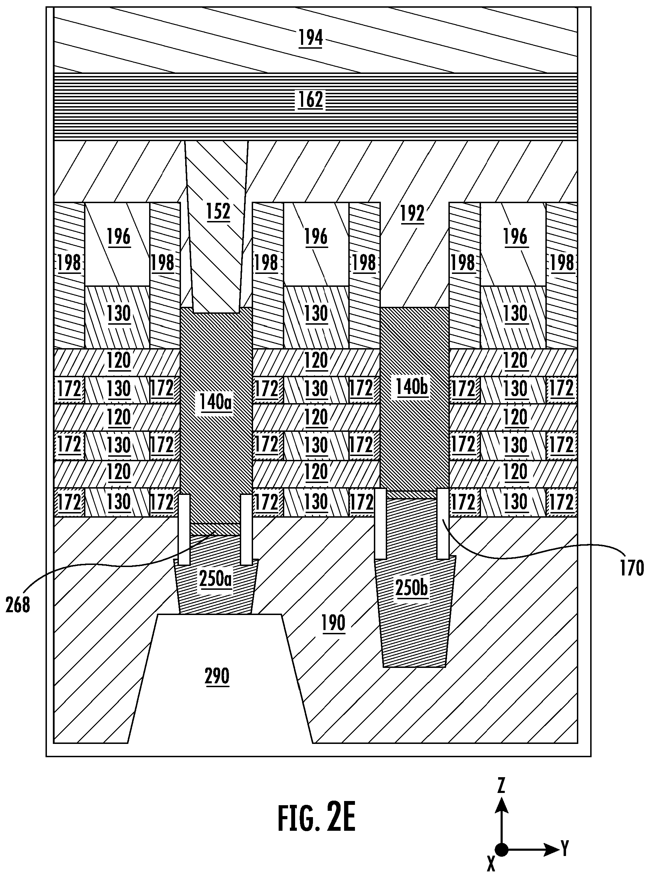

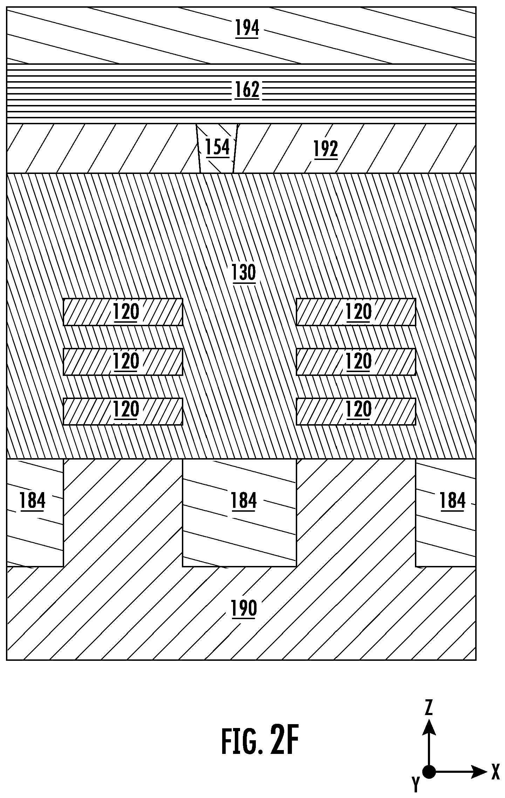

Forming a conventional BS contact using a conventional placeholder scheme may result in undesirable height variation of a placeholder BS contact, which may cause damage to an S/D that overlies the placeholder BS contact and/or may cause misalignment between the S/D and an adjacent channel layer. As described in further detail with respect to FIGs. 2A, 2B, 2C, 2D, 2E, and 2F, however, operations of forming the structure shown in FIG. 1C according to embodiments herein may use a non-SASI scheme that reduces height variation of a placeholder BS contact 250b (FIG. 2C) by forming a conductive spacer 170 (FIG. 2C). A height of the conductive spacer 170 may be finely controlled using, for example, organic planarization layer (OPL) chamfering.

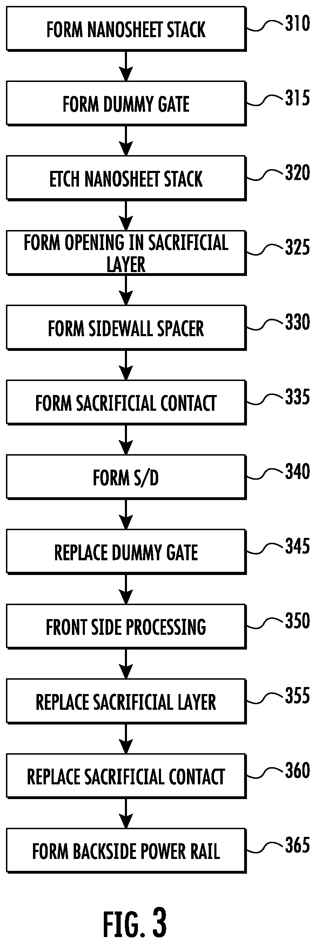

FIGs. 2A, 2B, 2C, 2D, 2E, and 2F are cross-sectional views illustrating operations of forming the structure shown in FIGs. 1C and 1E. FIGs. 2A, 2C, and 2E are cross-sections along the horizontal direction Y. FIGs. 2B, 2D, and 2F are cross-sections along the horizontal direction X. FIG. 3 is a flowchart corresponding to the operations shown in FIGs. 2A, 2B, 2C, 2D, 2E, and 2F. These operations use a non-SASI scheme that provides good control of the height of first and second placeholder (i.e., sacrificial) BS contacts 250a, 250b (FIG. 2C). The placeholder BS contacts 250a, 250b may collectively be referred to herein as placeholder BS contacts 250.

As shown in FIGs. 2A and 3, the operations of forming the structure shown in FIG. 1C may include forming (Block 310) a stack of semiconductor channel layers 120 on a substrate 210. In some embodiments, the channel layers 120 may be nanosheets, and the stack may thus be a nanosheet stack. Sacrificial gate layers 270 may be alternately stacked on the substrate 210 with the channel layers 120. Moreover, a sacrificial etch-stop layer 212 and a sacrificial interlayer region 262 may be between the substrate 210 and a lowermost one of the channel layers 120. The sacrificial interlayer region 262 may also be referred to herein as a "sacrificial layer."

The channel layers 120 may form part of the transistor 104 that is shown in FIG. 1C. The channel layers 120 may be semiconductor layers that comprise, for example, silicon (e.g., polysilicon). In a subsequent process/operation, the sacrificial gate layers 270 may be replaced with conductive gates 130 (FIG. 1C). Moreover, the sacrificial interlayer region 262 may be replaced with a BS isolation region 190 (FIG. 1C) in a subsequent process/operation.

The sacrificial gate layers 270 may comprise, for example, silicon germanium. Accordingly, the sacrificial gate layers 270 may have an etch selectivity relative to the channel layers 120. The sacrificial gate layers 270 may also have an etch selectivity relative to the sacrificial interlayer region 262. For example, the sacrificial interlayer region 262 and the sacrificial gate layers 270 may comprise silicon and silicon germanium, respectively. As an example, the sacrificial interlayer region 262 may comprise silicon that is epitaxially grown from the sacrificial etch-stop layer 212, which may be between the substrate 210 and the sacrificial interlayer region 262 in the vertical direction Z. According to some embodiments, the sacrificial etch-stop layer 212 and the sacrificial gate layers 270 may each comprise silicon germanium, but with different concentrations of germanium. As an example, the sacrificial etch-stop layer 212 may have a higher concentration of germanium (e.g., 55%) than the sacrificial gate layers 270 (e.g., 25%).

Referring still to FIGs. 2A and 3, a dummy gate 220 may be formed (Block 315) on the stack. As an example, a material of the dummy gate 220 may be formed (e.g., epitaxially grown or deposited) on the stack and then may be etched to provide segments of the dummy gate 220 that are spaced apart from each other in the horizontal direction Y. Moreover, a hardmask 230 may be formed on an upper surface of the dummy gate 220. The hardmask 230 may comprise, for example, an insulating material, such as an insulating compound that includes silicon.

Insulating spacers 232 may be formed on sidewalls of the dummy gate 220 and the hardmask 230, and the stack may be etched (Block 320). As a result, openings 234 may be formed between the channel layers 120. According to some embodiments, the hardmask 230 and the spacers 232 may protect underlying portions of the stack during the etch of the stack. The openings 234 may divide the stack shown in FIG. 2A into three stacks. Moreover, insulating spacers 172 may be formed on sidewalls of the sacrificial gate layers 270 through the openings 234.

In some embodiments, the insulating spacers 172 may be formed on sidewalls of the sacrificial gate layers 270 and between, in the vertical direction Z, the channel layers 120. For example, the sacrificial gate layers 270 may be etched (e.g., indented/narrowed in the horizontal direction Y) to form openings in the sacrificial gate layers 270 between the channel layers 120. Sidewalls of the sacrificial gate layers 270 may be exposed through the openings, and insulating the spacers 172 may be formed in the openings. According to some embodiments, an insulating material of the inuslating spacers 172 may be different from that of the hardmask 230 and/or different from an insulating material of the spacers 232. As an example, the spacers 232 may comprise silicon nitride (e.g., Si₃N₄).

The sacrificial etch-stop layer 212 may, in some embodiments, be thinner (in the vertical direction Z) than any layer between the sacrificial etch-stop layer 212 and a farthest one (i.e., highest) of the channel layers 120 from the sacrificial etch-stop layer 212. The sacrificial etch-stop layer 212 may therefore be thinner than any of the sacrificial gate layers 270, as well as thinner than any of the channel layers 120. Alternatively, the sacrificial etch-stop layer 212 may be thicker than any of the sacrificial gate layers 270, as well as thicker than any of the channel layers 120.

Referring further to FIGs. 2A and 3, openings 238 may be formed (Block 325) in the sacrificial interlayer region 262. The openings 238 may be formed by, for example, a dry etch and/or a wet etch process/operation performed through the openings 234. In some embodiments, the dry etch and/or wet etch (which may be isotropic) may form the openings 238 to have shapes that decrease in width (in the horizontal direction Y) as the openings 238 approach the substrate 210. For example, the openings 238 may be wider than the overlying openings 234, and may monotonically decrease in width as the openings 238 are farther from the openings 234. The openings 238 thus increase in width as the sacrificial interlayer region 262 approaches a lowermost one of the channel layers 120. As used herein, the term "opening in the sacrificial layer" may refer to an opening 238 and/or a lower portion of an opening 234 that is in the sacrificial interlayer region 262. As the opening 238 may be connected/contiguous with the opening 234, the opening 238 and the opening 234 may collectively be referred to herein as a single "opening."

A sidewall spacer 236 is formed (Block 330) in the openings 234. An upper portion of the sidewall spacer 236 may be on side surfaces of the spacers 232 and sidewalls of the channel layers 120. A lower portion of the sidewall spacer 236 may be in an upper portion of the sacrificial interlayer region 262. The openings 234 in which the sidewall spacer 236 is formed may thus extend into the upper portion of the sacrificial interlayer region 262. The sidewall spacer 236 may comprise a conductive material. In some embodiments, the sidewall spacer 236 may be formed by a barrier-metal deposition process/operation in the openings 234 and in the upper portion of (e.g., on an upper sidewall of) the sacrificial interlayer region 262. Accordingly, a barrier metal may be deposited as the sidewall spacer 236. The barrier metal may comprise, for example, titanium nitride and may be free of silicon. In contrast, a conventional sidewall spacer includes an insulating material, such as silicon nitride (e.g., Si₃N₄).

As shown in FIG. 2B, the operations of forming the structure shown in FIG. 1E may include forming STI regions 184 in the sacrificial interlayer region 262, on opposite sides of the stacks of channel layers 120. The dummy gate 220 may be formed on the STI regions 184, and on and between the stacks of channel layers 120.

As shown in FIG. 2C, the height of the sidewall spacer 236 (FIG. 2A) may be reduced, thereby forming a conductive spacer 170. For example, a chamfering process/operation may be performed on the sidewall spacer 236. In some embodiments, the chamfering process/operation may comprise controlling a height of the conductive spacer 170 by performing OPL chamfering and/or spin-on hardmask (SOH) chamfering on a conductive material (e.g., a barrier metal) of the sidewall spacer 236.

Moreover, the chamfering process/operation may include reducing the height of the sidewall spacer 236 until its upper surface is at a level lower than that of an upper surface of a lowermost one of the sacrificial gate layers 270, thus providing an upper portion of the conductive spacer 170 that overlaps the lowermost one of the sacrificial gate layers 270 in the horizontal direction Y and does not overlap a lowermost one of the channel layers 120 in the horizontal direction Y. Accordingly, an upper portion of the sidewall spacer 236 may be removed, including a portion of the sidewall spacer 236 that is formed on a sidewall of the lowermost one of the channel layers 120, thereby exposing (e.g., exposing an entirety of) the sidewall of the lowermost one of the channel layers 120, while a lower portion of the sidewall spacer 236 remains on a sidewall of the upper portion of the sacrificial interlayer region 262. The conductive spacer 170 that is formed by removing the upper portion of the sidewall spacer 236 does not overlap any channel layers 120 in the horizontal direction Y because such overlap could result in an electrical short.

As shown in FIG. 2C together with FIG. 3, placeholder BS contacts 250a, 250b may be formed (Block 335) in the openings 238 (FIG. 2A) and on a side surface of the conductive spacer 170. For example, lower portions of the placeholder BS contacts 250a, 250b may be formed in the openings 238, and upper portions of the placeholder BS contacts 250a, 250b may be formed on the side surface of the conductive spacer 170.

In some embodiments, the placeholder BS contacts 250 may be epitaxially grown from the sacrificial interlayer region 262. For example, the placeholder BS contacts 250 may comprise silicon germanium. The placeholder BS contacts 250 may thus have an etch selectivity relative to the sacrificial interlayer region 262, which may comprise silicon and be free of germanium.

According to some embodiments, upper portions of the placeholder BS contacts 250 may protrude upward (in the vertical direction Z) into the openings 234. The placeholder BS contacts 250 may thus be between opposite portions of the conductive spacer 170. Moreover, one of the placeholder BS contacts 250 may have a higher upper surface than the other one of the placeholder BS contacts 250, as long as semiconductor layers 268 on the placeholder BS contacts 250 do not overlap any channel layers 120 in the horizontal direction Y (as such overlap could result in an electrical short). Such a height difference between the placeholder BS contacts 250 can occur due to, for example, manufacturing process deviations. The placeholder BS contacts 250, however, are not required to have different heights. The upper surfaces of the placeholder BS contacts 250 may thus be coplanar in some embodiments. Moreover, though examples herein describe replacing the second placeholder BS contact 250b with the BS contact 150, the first placeholder BS contact 250a may instead be replaced with the BS contact 150 (and the second placeholder BS contact 250b may be replaced with an insulating material). In some embodiments, both the first and second placeholder BS contacts 250a and 250b may be replaced with the BS contact 150.

A target height 264 of the placeholder BS contacts 250a, 250b may be between (in the vertical direction Z) an upper surface of the conductive spacer 170 and a lower surface of the conductive spacer 170. As used herein, the term "target height" may refer to an intended/predetermined level of an upper surface of the first placeholder BS contact 250a and/or the second placeholder BS contact 250b. A process margin 266 of the placeholder BS contacts 250a, 250b in the vertical direction Z may be defined by the conductive spacer 170. For example, the process margin 266 may be equal, or similar, to a distance in the vertical direction Z between the upper surface of the conductive spacer 170 and the lower surface of the conductive spacer 170. A chamfering process according to embodiments herein can allow the target height 264 to be lower than a conventional target height, and thus can provide a wider process margin 266.

A semiconductor layer 268 may be between each of the placeholder BS contacts 250a, 250b and the S/D regions 140 in the vertical direction Z. The semiconductor layer 268 may be a semiconductor buffer (e.g., blocking) layer that is formed on the upper surface of each placeholder BS contact 250. As an example, the semiconductor layer 268 may be a relatively thin silicon layer that is epitaxially grown from each placeholder BS contact 250. For example, the semiconductor layer 268 may be thinner (e.g., may have a thickness of about 4 nm), in the vertical direction Z, than each of the channel layers 120. An upper surface of the semiconductor layer 268 may be coplanar with, or at a lower level (in the vertical direction Z) than, an upper surface of a lowermost one of the sacrificial gate layers 270. According to some embodiments, the semiconductor layer 268 may be free of germanium.

As is further shown in FIG. 2C together with FIG. 3, S/D regions 140 may be formed (Block 340) in the openings 234, on the placeholder BS contacts 250 and the semiconductor layer 268. According to some embodiments, the S/D regions 140 may be wider, in the horizontal direction Y, than the semiconductor layer 268, and thus may overlap the conductive spacer 170 in the vertical direction Z.

In some embodiments, the S/D regions 140 may be formed by epitaxial growth. For example, the S/D regions 140 may be epitaxially grown from the channel layers 120. According to some embodiments, the channel layers 120 may comprise silicon, and the S/D regions 140 may comprise silicon, silicon carbide, or silicon germanium.

An FS isolation region 192 may be formed in the openings 234, on the S/D regions 140. As an example, the FS isolation region 192 may be formed by filling the openings 234 with an oxide material and then performing a planarization operation/process (e.g., chemical-mechanical planarization (CMP)).

FIG. 2C also shows that the hardmask 230 (FIG. 2A) may be removed, and the spacers 232 (FIG. 2A) may be vertically thinned, by performing a further planarization operation/process. For example, a silicon-nitride CMP may be performed. After the CMP, upper surfaces of the dummy gate 220 may be exposed. As a result of vertically thinning the spacers 232, isolation regions (e.g., sidewall spacers) 198 may be provided.

Each of the placeholder BS contacts 250 includes an upper portion having a straight, vertical sidewall s₁ and a lower portion having a sloped/angled side surface s₂. The sidewall s₁ may be parallel with the vertical direction Z, and the side surface s₂ may form an acute angle with the vertical direction Z. The sidewall s₁ may be in contact with a side surface of the conductive spacer 170, and the side surface s₂ may be in contact with the sacrificial interlayer region 262.

For ease of differentiating between the two different placeholder BS contacts 250 shown in FIG. 2C, one of the placeholder BS contacts 250 is labeled 250a, which may be referred to herein as a "first" placeholder BS contact, and another is labeled 250b, which may be referred to herein as a "second" placeholder BS contact. The first placeholder BS contact 250a may be thinner than the second placeholder BS contact 250b in the vertical direction Z. As an example, the upper portion of the second placeholder BS contact 250b may be vertically thicker than the upper portion of the first placeholder BS contact 250a. The upper surface of the second placeholder BS contact 250b may thus be at a higher level, in the vertical direction Z, than the upper surface of the first placeholder BS contact 250a. For example, the sacrificial interlayer region 262 may be on side surfaces of the placeholder BS contacts 250a, 250b, and the upper portion of the second placeholder BS contact 250b may protrude upward in the vertical direction Z beyond the upper surface of the sacrificial interlayer region 262, whereas the upper surface of the first placeholder BS contact 250a may be at level that is below that of the upper surface of the sacrificial interlayer region 262. According to some embodiments, a lower surface of the first placeholder BS contact 250a may be coplanar with a lower surface of the second placeholder BS contact 250b.

The terms "placeholder" and "sacrificial" may be used interchangeably herein. Both of these terms may refer to a material/structure that will subsequently be removed and/or replaced with another material/structure. For example, the first placeholder BS contact 250a may be epitaxially grown and may subsequently be replaced with an insulating material. Moreover, the second placeholder BS contact 250b may be epitaxially grown and may subsequently be replaced with a conductive (e.g., metal) material. The placeholder BS contacts 250 may therefore also be referred to herein as "sacrificial" BS contacts.

The placeholder BS contacts 250 and the conductive spacer 170 may collectively be referred to herein as "preliminary" BS contacts. A preliminary BS contact may thus include two portions: (i) the conductive spacer 170; and (ii) the placeholder BS contact 250, which comprises a sacrificial material that is formed on the conductive spacer 170. For a first preliminary BS contact that includes the conductive spacer 170 and the second placeholder BS contact 250b, the conductive spacer 170 will subsequently serve as a barrier metal for a BS contact 150 (FIG. 1C) and the second placeholder BS contact 250b will subsequently be replaced with the BS contact 150. On the other hand, for a second preliminary BS contact that includes the conductive spacer 170 and the first placeholder BS contact 250a, both portions may be placeholders, as they may both be subsequently removed and replaced with an insulating material.

In some embodiments, the first preliminary BS contact may be formed concurrently with the second preliminary BS contact. For example, the conductive spacer 170 may be formed (e.g., the sidewall spacer 236 may be etched/chamfered) concurrently in two openings 234. In some example embodiments, the first placeholder BS contact 250a may be formed (e.g., epitaxially grown) concurrently with the second placeholder BS contact 250b. According to some embodiments, the first placeholder BS contact 250a and the second placeholder BS contact 250b may each comprise the same sacrificial material, such as the same epitaxially-grown material.

As shown in FIG. 2D, the hardmask 230 (FIG. 2B) may be removed. As a result, an upper surface of the dummy gate 220 may be exposed. The hardmask 230 may be removed by, for example, an etching process that targets a material of the hardmask 230. As an example, the hardmask 230 may comprise a dielectric, such as silicon dioxide, silicon carbide, or amorphous carbon, or a metal, such as titanium nitride.

As shown in FIGs. 2E and 3, the dummy gate 220 (FIG. 2C) and the sacrificial gate layers 270 (FIG. 2C) may be replaced (Block 345) with a conductive gate 130. For example, the conductive gate 130 may comprise a high-k metal gate or another type of conductive gate. As used herein, the term "high-k" refers to an insulating material having a higher dielectric constant than silicon dioxide. Though omitted from view in the drawings for simplicity of illustration, gate insulation layers may, according to some embodiments, be formed between the gate 130 and the channel layers 120.

An isolation region 196 may be formed as a capping layer on an upper surface of the gate 130. The isolation region 196 may be between opposite portions of the isolation region 198. For example, each of the opposite portions of the isolation region 198 may be a sidewall spacer, and the isolation region 196 may be between a pair of the sidewall spacers.

Referring still to FIGs. 2E and 3, FS processing may be performed (Block 350). The FS processing may include forming the FS isolation region 192 on the gate 130 and the isolation regions 196, 198. For example, an upper portion of the FS isolation region 192 may be formed on a lower portion thereof that is already on the S/D regions 140. Moreover, the FS processing may include forming an FS contact 152 on an upper surface of the first S/D region 140a. An upper portion of the FS contact 152 may be in an opening in the FS isolation region 192, and may be in contact with a lower surface of an FS conductive layer 162 that is formed on an upper surface of the FS isolation region 192. The FS conductive layer 162 may be formed by, for example, a BEOL operation/process.

In some embodiments, wafer bonding (e.g., carrier wafer bonding) may be performed on the FS of the structure after forming the FS contact 152. As an example, a wafer (e.g., a substrate) 194 may be bonded to the FS conductive layer 162. The wafer 194 may thus be referred to herein as an "FS" wafer/substrate, and the substrate 210 (FIG. 2C) may be referred to herein as a "BS" substrate 210.

As is further shown in FIG. 2E, the BS substrate 210 may be removed after bonding the FS wafer 194. Removal of the BS substrate 210 can expose a lower surface of the sacrificial etch-stop layer 212 (FIG. 2C), which may have an etch selectivity with respect to the BS substrate 210 and the sacrificial interlayer region 262. The sacrificial etch-stop layer 212 may then be removed, thereby exposing a lower surface of the sacrificial interlayer region 262 that is on the placeholder BS contacts 250. Due to an etch selectivity between the sacrificial etch-stop layer 212 and the placeholder BS contacts 250, the sacrificial etch-stop layer 212 can be removed without damaging the placeholder BS sacrificial contacts 250. This etch selectivity may result from, for example, a germanium concentration in the sacrificial etch-stop layer 212 that is different from a germanium concentration in the placeholder BS contacts 250.

Referring further to FIG. 2E together with FIG. 3, the sacrificial interlayer region 262 may be replaced (Block 355) with a BS isolation region 190. For example, the sacrificial interlayer region 262, which has an etch selectivity with respect to the placeholder BS contacts 250 and the conductive spacer 170, may be removed by etching. According to some embodiments, the BS isolation region 190 may comprise an oxide (e.g., silicon oxide) and may be formed by performing an oxide fill operation/process on a side surface of the conductive spacer 170, a lower surface of the gate 130, and side and lower surfaces of the placeholder BS contacts 250.

An opening 290 may be formed in the BS isolation region 190 to expose the lower surface of the first placeholder BS contact 250a, while the lower surface of the second placeholder BS contact 250b remains covered by (e.g., in contact with) the BS isolation region 190. The first placeholder BS contact 250a, along with the conductive spacer 170 thereon and the semiconductor layer 268 thereon, may (subsequently) be removed through the opening 290.

As shown in FIG. 2F, a gate contact 154 may be formed in the FS isolation region 192. As an example, the gate contact 154 may be formed in an opening in the FS isolation region 192 that exposes an upper surface of the gate 130. Accordingly, a lower surface of the gate contact 154 may be in contact with the upper surface of the gate 130. Moreover, the FS conductive layer 162 may be formed on (e.g., in contact with) an upper surface of the gate contact 154.

Referring to FIG. 1C together with FIG. 3, the placeholder BS contacts 250 may be replaced (Block 360). For example, a sacrificial material of the first placeholder BS contact 250a may be removed through the opening 290 (FIG. 2E) and may be replaced by an insulating material, such as by performing an oxide fill operation/process in the opening 290 after removing the first placeholder BS contact 250a. As a result, the BS isolation region 190 may expand to fill a location that had been occupied by the first placeholder BS contact 250a. This replacement of the first placeholder BS contact 250a (and the conductive spacer 170 thereon) with the BS isolation region 190 can help to impede/prevent an electrical short of a transistor 104 (FIG. 1C).

In some embodiments, a sacrificial material of the second placeholder BS contact 250b may be removed and replaced with a conductive BS contact 150 that is formed on the conductive spacer 170, in the BS isolation region 190. As an example, the placeholder BS contacts 250a, 250b may be removed concurrently by an etch operation/process that has an etch selectivity with respect to the BS isolation region 190 and the conductive spacer 170. In another example, however, the first placeholder BS contact 250a may be removed through the opening 290 before removing the second placeholder BS contact 250b, thereby helping to protect the conductive spacer 170 that is on the second placeholder BS contact 250b from removal while removing the conductive spacer 170 that is on the first placeholder BS contact 250a through the opening 290. According to some embodiments, a conductive material (of the BS contact 150) that replaces the second placeholder BS contact 250b can provide a largest (e.g., main/primary/body) portion of the BS contact 150, and the conductive spacer 170 can provide a barrier metal of/for the BS contact 150.

The semiconductor layer 268 may serve as an etch-stop layer during removal of the placeholder BS contacts 250. In some embodiments, the semiconductor layer 268 may be removed after removing the placeholder BS contacts 250, thereby exposing lower surfaces of the S/D regions 140. The BS contact 150 may thus be formed to be in contact with the lower surface of the second S/D region 140b. In other embodiments, the semiconductor layer 268 may remain on the lower surface of the second S/D region 140b, and therefore may intervene between the second S/D region 140b and the BS contact 150 in the vertical direction Z.

The BS contact 150 comprises a conductive material (e.g., a metal). In some embodiments, the BS contact 150 may comprise the same conductive material (e.g., the same metal) as the FS contact 152 (FIG. 1C) and/or the gate contact 154 (FIG. 1E). Moreover, the BS contact 150 may be formed by a BS contact (e.g., metal) fill operation/process in an opening in the BS isolation region 190. A material formed by the BS contact fill operation/process may then be planarized (e.g., by CMP) to expose a lower surface of the BS isolation region 190. The BS contact 150 may thus have a lower surface that is coplanar with a lower surface of the BS isolation region 190.

Referring to FIGs. 1C and 1E together with FIG. 3, a BS power rail 160 may be formed (Block 365) on the lower surface of the BS isolation region 190. As shown in FIG. 1C, a lower surface (i.e., a BS) of the BS contact 150 may be on (e.g., in contact with) an upper surface of the BS power rail 160. The lower surface of the BS contact 150 is a lower surface of a lower portion p₃ (FIG. 1D) thereof that can be wider in the horizontal direction Y than any portion of the second placeholder BS contact 250b (FIG. 2E) that is replaced by the BS contact 150.

According to some embodiments, the lower portion p₃ of the BS contact 150 may have the size and shape of the opening 290 (FIG. 2E). For example, the opening 290 may be repeated so that it is also formed under the second S/D region 140b. In some embodiments, this additional opening 290 may be formed in the BS isolation region 190 after filling the original opening 290 with an insulating material. The conductive spacer 170 that is on the second placeholder BS contact 250b may be protected from removal because it may not be exposed through the additional opening 290 until after the conductive spacer 170 that is on the first placeholder BS contact 250a is removed through the original opening 290.

Methods of forming devices 100 (FIG. 1A) according to some embodiments herein may provide various advantages. These advantages include forming placeholder BS contacts 250a, 250b (FIG. 2C) with improved control over heights of upper surfaces thereof by first forming a conductive spacer 170 (FIG. 2C). A height (e.g., level) of an upper surface of the conductive spacer 170 may be finely controlled using OPL/SOH chamfering, and this can help to control the heights of the placeholder BS contacts 250a, 250b. The first BS contact 250a, and the conductive spacer 170 thereon, may be replaced with an insulating material. The second BS contact 250b may be replaced with a conductive BS contact 150 (FIG. 1C) having an upper portion p₁ (FIG. 1D) that is on (e.g., in contact with) a side surface of the conductive spacer 170. The conductive spacer 170 may serve as a barrier metal for the BS contact 150, and can thus help to reduce contact resistance between the BS contact 150 and an overlying S/D region 140b (FIG. 1C).

Example embodiments are described herein with reference to the accompanying drawings. Many different forms and embodiments are possible without deviating from the teachings of this disclosure and so the disclosure should not be construed as limited to the example embodiments set forth herein. Rather, these example embodiments are provided so that this disclosure will be thorough and complete, and will convey the scope of the present invention which is solely defined by the appended set of claims. In the drawings, the sizes and relative sizes of layers and regions may be exaggerated for clarity. Like reference numbers refer to like elements throughout.

Example embodiments are described herein with reference to cross-sectional illustrations that are schematic illustrations of idealized embodiments and intermediate structures of example embodiments. As such, variations from the shapes of the illustrations as a result, for example, of manufacturing techniques and/or tolerances, are to be expected. Thus, embodiments herein should not be construed as limited to the particular shapes illustrated herein but may include deviations in shapes that result, for example, from manufacturing.

It should also be noted that in some alternate implementations, the functions/acts noted in flowchart blocks herein may occur out of the order noted in the flowcharts. For example, two blocks shown in succession may in fact be executed substantially concurrently or the blocks may sometimes be executed in the reverse order, depending upon the functionality/acts involved. Moreover, the functionality of a given block of the flowcharts and/or block diagrams may be separated into multiple blocks and/or the functionality of two or more blocks of the flowcharts and/or block diagrams may be at least partially integrated. Finally, other blocks may be added/inserted between the blocks that are illustrated, and/or blocks/operations may be omitted without departing from the scope of the present invention.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including," when used in this specification, specify the presence of the stated features, steps, operations, elements, and/or components, but do not preclude the presence or addition of one or more other features, steps, operations, elements, components, and/or groups thereof.

It will be understood that when an element is referred to as being "coupled," "connected," or "responsive" to, or "on," another element, it can be directly coupled, connected, or responsive to, or on, the other element, or intervening elements may also be present. In contrast, when an element is referred to as being "directly coupled," "directly connected," or "directly responsive" to, or "directly on," another element, there are no intervening elements present. As used herein, the term "and/or" includes any and all combinations of one or more of the associated listed items. Moreover, the symbol "/" (e.g., when used in the term "source/drain") will be understood to be equivalent to the term "and/or."

It will be understood that although the terms "first," "second," etc. may be used herein to describe various elements, these elements should not be limited by these terms. These terms are only used to distinguish one element from another. Thus, a first element could be termed a second element without departing from the teachings of the present embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if a device in the figures is turned over, elements described as "below" or "beneath" other elements or features would then be oriented "above" the other elements or features. Thus, the term "below" can encompass both an orientation of above and below. The device may be otherwise oriented (e.g., rotated 90 degrees or at other orientations) and the spatially relative descriptors used herein may be interpreted accordingly.

Many different embodiments have been disclosed herein, in connection with the above description and the drawings. It will be understood that it would be unduly repetitious and obfuscating to literally describe and illustrate every combination and subcombination of these embodiments. Accordingly, the invention is solely defined by the appended set of claims.

## Claims

1. A method of forming a semiconductor device (100), the method comprising:
forming a preliminary backside, BS, source/drain, S/D, contact (170, 250) that comprises a barrier metal (170) and a sacrificial BS S/D contact (250);
and replacing the sacrificial BS S/D contact (250) with a BS S/D contact (150) formed directly on the barrier metal (170),
the method comprising:
etching a sacrificial layer (262) having a stack of channel layers (120) thereon, thereby forming a first opening (234) in the stack of channel layers (120) and a second opening (238) in the sacrificial layer (262);
forming a metal spacer (170) in the second opening (238), wherein forming the metal spacer (170) comprises: depositing the barrier metal (170) on a sidewall of the sacrificial layer (262), in the second opening (238) and removing the barrier metal (170) from a sidewall of a lowermost one of the channel layers (120), while the barrier metal (170) remains on the sidewall of the sacrificial layer (262);
replacing the sacrificial layer (262) with an isolation region (190), after forming the metal spacer (170);
forming a sacrificial BS S/D contact (250) in the second opening (238) on a sidewall of the barrier metal (170); and
forming the BS S/D contact (150) on the metal spacer (170), in the isolation region (190), wherein forming the BS S/D contact (150) comprises replacing the sacrificial BS S/D contact (250) with the BS S/D contact (150).

2. The method of Claim 1, wherein forming the preliminary BS S/D contact (170, 250) comprises depositing the barrier metal (170).

3. The method of Claim 2, wherein depositing the barrier metal (170) comprises depositing the barrier metal (170) as a sidewall spacer (236).

4. The method of Claim 3, wherein forming the BS S/D contact (150) comprises forming a sidewall of an upper portion of the BS S/D contact (150) on the sidewall spacer (236).

5. The method of Claim 3 or 4,
wherein forming the preliminary BS S/D contact (170, 250) further comprises forming a sacrificial material on the sidewall spacer (236), and
wherein forming the BS S/D contact (150) comprises replacing the sacrificial material with the BS S/D contact (150).

6. The method of Claim 5, further comprising:
forming an S/D region (140) on the barrier metal (170), before removing the sacrificial material.

7. The method of any one of Claims 1 to 6,
wherein the preliminary BS S/D contact (170, 250) is a first preliminary BS S/D contact (170, 250b),
wherein the method further comprises:
forming a second preliminary BS S/D contact (170, 250a) that comprises the barrier metal (170), concurrently with forming the first preliminary BS S/D contact (170, 250b);
replacing the second preliminary BS S/D contact (170, 250a) with an insulating material; and
forming a BS conductive line (160) on the insulating material and the BS S/D contact (150), and
wherein the BS conductive line (160) is electrically connected to the BS S/D contact (150).

8. The method of any one of Claims 1 to 7, further comprising:
replacing the sacrificial layer (262) with an isolation region (190), after forming the preliminary BS S/D contact (170, 250).

9. The method of Claim 8, wherein forming the preliminary BS S/D contact (170, 250) comprises:
forming the barrier metal (170) on a sidewall of a lowermost one of the channel layers (120); and
removing an upper portion of the barrier metal (170), thereby exposing the sidewall of the lowermost one of the channel layers (120).

10. The method of any one of the preceding Claims, further comprising forming a BS conductive line (160) on a BS of the BS S/D contact (150).

11. The method of any one of the preceding claims, wherein the barrier metal (170) comprises titanium nitride and is free of silicon.

## Patentansprüche

1. Verfahren zur Herstellung einer Halbleitervorrichtung (100), wobei das Verfahren umfasst:
Bilden eines vorläufigen, auf einer Rückseite, BS, befindlichen Source/Drain-, S/D-, Kontakts (170, 250), der ein Barrierenmetall (170) und einen BS-S/D-Opfer-Kontakt (250) umfasst; und
Ersetzen des BS-S/D-Opfer-Kontakts (250) durch einen BS-S/D-Kontakt (150), der direkt auf dem Barrierenmetall (170) ausgebildet ist,
wobei das Verfahren umfasst:
Ätzen einer Opferschicht (262), auf der sich ein Stapel von Kanalschichten (120) befindet, wodurch eine erste Öffnung (234) in dem Stapel von Kanalschichten (120) und eine zweite Öffnung (238) in der Opferschicht (262) gebildet werden;
Bilden eines Metallabstandshalters (170) in der zweiten Öffnung (238), wobei das Bilden des Metallabstandshalters (170) umfasst: Aufbringen des Barrierenmetalls (170) auf eine Seitenwand der Opferschicht (262) in der zweiten Öffnung (238) und Entfernen des Barrierenmetalls (170) von einer Seitenwand einer untersten der Kanalschichten (120), während das Barrierenmetall (170) auf der Seitenwand der Opferschicht (262) verbleibt;
Ersetzen der Opferschicht (262) durch einen Isolationsbereich (190) nach dem Bilden des Metallabstandshalters (170);
Bilden eines BS-S/D-Opfer-Kontakts (250) in der zweiten Öffnung (238) auf einer Seitenwand des Barrierenmetalls (170); und
Bilden des BS-S/D-Kontakts (150) auf dem Metallabstandshalter (170) in dem Isolationsbereich (190), wobei das Bilden des BS-S/D-Kontakts (150) das Ersetzen des BS-S/D-Opfer-Kontakts (250) durch den BS-S/D-Kontakt (150) umfasst.

2. Verfahren nach Anspruch 1, wobei das Bilden des vorläufigen BS-S/D-Kontakts (170, 250) das Aufbringen des Barrierenmetalls (170) umfasst.

3. Verfahren nach Anspruch 2, wobei das Aufbringen des Barrierenmetalls (170) das Aufbringen des Barrierenmetalls (170) als ein Seitenwandabstandshalter (236) umfasst.

4. Verfahren nach Anspruch 3, wobei das Ausbilden des BS-S/D-Kontakts (150) das Bilden einer Seitenwand eines oberen Abschnitts des BS-S/D-Kontakts (150) auf dem Seitenwandabstandshalter (236) umfasst.

5. Verfahren nach Anspruch 3 oder 4,
wobei das Bilden des vorläufigen BS-S/D-Kontakts (170, 250) ferner das Bilden eines Opfermaterials auf dem Seitenwandabstandshalter (236) umfasst, und
wobei das Bilden des BS-S/D-Kontakts (150) ein Ersetzen des Opfermaterials durch den BS-S/D-Kontakt (150) umfasst.

6. Verfahren nach Anspruch 5, ferner umfassend:
Bilden eines S/D-Bereichs (140) auf dem Barrierenmetall (170) vor dem Entfernen des Opfermaterials.

7. Verfahren nach einem der Ansprüche 1 bis 6,
wobei der vorläufige BS-S/D-Kontakt (170, 250) ein erster vorläufiger BS-S/D-Kontakt (170, 250b) ist,
wobei das Verfahren ferner umfasst:
Bilden eines das Barrierenmetall (170) umfassenden, zweiten vorläufigen BS-S/D-Kontakts (170, 250a) gleichzeitig mit dem Bilden des ersten vorläufigen BS-S/D-Kontakts (170, 250b);
Ersetzen des zweiten vorläufigen BS-S/D-Kontakts (170, 250a) durch ein Isoliermaterial; und
Bilden einer BS-Leiterbahn (160) auf dem Isoliermaterial und dem BS-S/D-Kontakt (150), und
wobei die BS-Leiterbahn (160) mit dem BS-S/D-Kontakt (150) elektrisch verbunden ist.

8. Verfahren nach einem der Ansprüche 1 bis 7, ferner umfassend:
Ersetzen der Opferschicht (262) durch einen Isolationsbereich (190) nach dem Bilden des vorläufigen BS-S/D-Kontakts (170, 250).

9. Verfahren nach Anspruch 8, wobei das Bilden des vorläufigen BS-S/D-Kontakts (170, 250) umfasst:
Bilden des Barrierenmetalls (170) auf einer Seitenwand einer untersten von den Kanalschichten (120); und
Entfernen eines oberen Abschnitts des Barrierenmetalls (170), wodurch die Seitenwand der untersten von den Kanalschichten (120) freigelegt wird.

10. Verfahren nach einem der vorstehenden Ansprüche, das ferner das Bilden einer BS-Leiterbahn (160) auf einer BS des BS-S/D-Kontakts (150) umfasst.

11. Verfahren nach einem der vorstehenden Ansprüche, wobei das Barrierenmetall (170) Titannitrid aufweist und frei von Silizium ist.

## Revendications

1. Procédé de formation d'un dispositif à semi-conducteur (100), le procédé comprenant les étapes suivantes :
former un contact préliminaire de source/drain de face arrière (170, 250), comprenant un métal barrière (170) et un contact sacrificiel de source/drain de face arrière (250) ; et
remplacer le contact sacrificiel de source/drain de face arrière (250) par un contact de source/drain de face arrière (150) formé directement sur le métal barrière (170),
le procédé comprenant en outre les étapes suivantes :
graver une couche sacrificielle (262) sur laquelle est disposé un empilement de couches de canal (120), formant ainsi une première ouverture (234) dans l'empilement de couches de canal (120) et une deuxième ouverture (238) dans la couche sacrificielle (262) ;
former un espaceur métallique (170) dans la deuxième ouverture (238), en déposant le métal barrière (170) sur une paroi latérale de la couche sacrificielle (262), dans la deuxième ouverture (238), et en retirant le métal barrière (170) d'une paroi latérale de la couche de canal la plus basse, tandis que le métal barrière (170) demeure sur la paroi latérale de la couche sacrificielle (262) ;
remplacer la couche sacrificielle (262) par une région d'isolation (190), après avoir formé l'espaceur métallique (170) ;
former un contact sacrificiel de source/drain de face arrière (250) dans la deuxième ouverture (238), sur une paroi latérale du métal barrière (170) ; et
former le contact de source/drain de face arrière (150) sur l'espaceur métallique (170), dans la région d'isolation (190), en remplaçant le contact sacrificiel de source/drain de face arrière (250) par le contact de source/drain de face arrière (150).

2. Procédé selon la revendication 1, dans lequel la formation du contact préliminaire de source/drain de face arrière (170, 250) comprend l'étape suivante: déposer le métal barrière (170).

3. Procédé selon la revendication 2, dans lequel le métal barrière (170) est déposé sous la forme d'un espaceur latéral (236).

4. Procédé selon la revendication 3, dans lequel une paroi latérale d'une partie supérieure du contact de source/drain de face arrière (150) est formée sur l'espaceur latéral (236).

5. Procédé selon la revendication 3 ou 4, dans lequel la formation du contact préliminaire de source/drain de face arrière (170, 250) comprend en outre l'étape suivante :
former un matériau sacrificiel sur l'espaceur latéral (236), et
dans lequel la formation du contact de source/drain de face arrière (150) comprend l'étape suivante :
remplacer le matériau sacrificiel par le contact de source/drain de face arrière (150).

6. Procédé selon la revendication 5, comprenant en outre l'étape suivante :
former une région de source/drain (140) sur le métal barrière (170), avant de retirer le matériau sacrificiel.

7. Procédé selon l'une quelconque des revendications 1 à 6,
dans lequel le contact préliminaire de source/drain de face arrière (170, 250) constitue un premier contact préliminaire de source/drain de face arrière (170, 250b),
dans lequel le procédé comprend en outre les étapes suivantes :
former un deuxième contact préliminaire de source/drain de face arrière (170, 250a) qui comprend le métal barrière (170), simultanément à la formation du premier contact préliminaire de source/drain de face arrière (170, 250b) ;
remplacer le deuxième contact préliminaire de source/drain de face arrière (170, 250a) par un matériau isolant ; et
former une ligne conductrice de face arrière (160) sur le matériau isolant et le contact de source/drain de face arrière (150),
la ligne conductrice de face arrière (160) étant électriquement connectée au contact de source/drain de face arrière (150).

8. Procédé selon l'une quelconque des revendications 1 à 7, comprenant en outre l'étape suivante:
remplacer la couche sacrificielle (262) par une région d'isolation (190), après avoir formé le contact préliminaire de source/drain de face arrière (170, 250).

9. Procédé selon la revendication 8, dans lequel la formation du contact préliminaire de source/drain de face arrière (170, 250) comprend les étapes suivantes :
former le métal barrière (170) sur une paroi latérale de la couche de canal la plus basse ; et
retirer une partie supérieure du métal barrière (170), exposant ainsi la paroi latérale de la couche de canal la plus basse.

10. Procédé selon l'une quelconque des revendications précédentes, comprenant en outre l'étape suivante : former une ligne conductrice de face arrière (160) sur une face arrière du contact de source/drain de face arrière (150).

11. Procédé selon l'une quelconque des revendications précédentes, dans lequel le métal barrière (170) comprend du nitrure de titane et est exempt de silicium.
